(19) Europäisches Patentamt
European Patent Office
Office européen des brevets

(11) Numéro de publication: **0 060 221**
**B1**

(12) # FASCICULE DE BREVET EUROPEEN

(45) Date de publication du fascicule du brevet: **03.07.85**

(51) Int. Cl.⁴: **C 23 C 16/00**, B 05 B 7/10, C 03 C 17/245

(21) Numéro de dépôt: **82810096.6**

(22) Date de dépôt: **04.03.82**

(54) **Procédé pour déposer sur un substrat un revêtement d'oxyde minéral et dispositif d'application.**

(30) Priorité: **06.03.81 CH 1520/81**

(43) Date de publication de la demande: **15.09.82 Bulletin 82/37**

(45) Mention de la délivrance du brevet: **03.07.85 Bulletin 85/27**

(84) Etats contractants désignés: **AT BE CH DE FR GB IT LI LU NL SE**

(56) Documents cités:
**DD - A - 107 723**
**FR - A - 926 438**
**FR - A - 1 089 640**
**FR - A - 1 518 843**
**FR - A - 2 348 165**
**US - A - 3 511 703**
**US - A - 3 524 590**

(73) Titulaire: **BATTELLE MEMORIAL INSTITUTE, 7 route de Drize, CH-1227 Carouge/Genève (CH)**

(72) Inventeur: **Baumberger, Otto, 18 rue des Caroubiers, CH-1227 Carouge (CH)**
Inventeur: **Kalbskopf, Reinhard, 103, avenue du Bois de la Chapelle, CH-1213 Onex (CH)**

(74) Mandataire: **Dousse, Blasco et al, 7, route de Drize, CH-1227 Carouge/Genève (CH)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).



ACTORUM AG

## Description

La présente invention a pour objet un procédé pour revêtir au moins une partie d'un substrat d'une couche de matière minérale; elle a également pour objet un dispositif pour mettre en œuvre ce procédé.

Le présent procédé est basé sur la technique dite CVD (chemical vapor deposition) qui consiste à diriger sur un substrat porté à température élevée des courants gazeux d'un ou plusieurs réactifs, ceux-ci s'unissant sur le substrat ou à proximité immédiate de celui-ci en y déposant, sous forme d'un revêtement plus ou moins uniforme, un produit solide résultant d'une décomposition ou d'une réaction chimique desdits réactifs. Dans la pratique habituelle, on guide les gaz réactifs sur le substrat au moyen de tuyères agencées de manière qu'au point de rencontre le mélange de ceux-ci s'opère progressivement dans des conditions non turbulentes, les mouvements tourbillonnaires susceptibles d'engendrer une réaction prématurée des réactifs gazeux et le dépôt d'une partie du produit solide sur l'extrémité desdites tuyères et des autres organes du dispositif de revêtement étant évités dans la mesure du possible. En effet, de tels dépôts parasites encrassent le dispositif et en modifient rapidement les caractéristiques opérationnelles ce qui est excessivement néfaste.

Le US-A-3 511 703 se rapporte à un procédé de revêtement d'un substrat par dépôt d'oxydes métalliques selon la technique CVD. Le dépôt est obtenu par réaction à chaud de deux flux de gaz inerte saturés chacun par un réactif. Selon ce procédé, les gaz saturés sont envoyés dans deux tuyères respectives concentriques l'une à l'autre de sorte que les deux flux de gaz se mélangent à la sortie de la buse formée par les ouvertures de distribution de ces tuyères. Ce mélange se produit au-dessus du substrat qui est maintenu à la température appropriée pour engendrer la réaction. On trouvera d'autres détails sur les procédés et dispositifs antérieurs de revêtement par CVD par exemple dans les références suivantes: Fr 2 083 818; BE 877 465; USP 3 850 679; FR 2 314 152; CH 7 033 79.

Or on a maintenant trouvé qu'il pouvait être avantageux, dans un procédé de formation de revêtement d'oxydes métalliques par CVD, de provoquer au point de contact un mélange aussi instantané que possible des réactifs en phase vapeur, ceci en provoquant un maximum de turbulence et d'effet tourbillonnaire des flux gazeux. On a en effet constaté que les dépôts réalisés dans de telles conditions sont très réguliers et homogènes, que les grains de dépôt sont très fins et, en tout cas, d'une dimension inférieure aux longueurs d'onde de la lumière visible ce qui supprime les défauts dûs à la diffraction. On y parvient le plus simplement, soit en faisant se rencontrer lesdits flux gazeux sous un angle nettement différent de zéro degré, soit en les animant de vitesses nettement différentes, soit en combinant ces deux effets.

Par angle de rencontre des flux gazeux, on veut parler de l'angle que forment entre eux, au point d'impact, les vecteurs de déplacement des courants de réactif en phase vapeur. Dans l'invention, cet angle est d'au moins 35° et, de préférence de 60 à 180°. Par vitesses nettement différentes, on veut dire que l'un des flux gazeux se déplace au moins 1,5 à 2 fois plus vite que l'autre, la différence entre les deux pouvant être cependant beaucoup plus grande, par exemple de 10:1 ou même de 20:1. Bien entendu, ces considérations sont aussi valables si le nombre des courants de gaz dépasse deux, c'est-à-dire, par exemple si la réaction fait intervenir trois (ou plus) réactivs gazeux indépendants ou si, dans le cas de deux réactifs, ceux-ci sont amenés au point de contact par plus de deux tuyères. Dans un tel cas, il suffit (mais cela n'est pas obligatoirement le cas) que seuls deux des courants gazeux obéissent aux conditions sus-mentionnées. Il est aussi bien entendu que, dans tous ces cas, on tiendra compte des exigences de la stoechiométrie réactionnelle des participants en ce sens que, par exemple dans le cas où une réaction fait intervenir à l'origine des volumes égaux des réactifs, le courant le plus rapide sera plus dilué (par exemple au moyen d'un gaz porteur) que le courant le plus lent, ceci justement en fonction des différences de vitesses. Ou bien, l'orifice des tuyères d'amenée des gaz sera adapté en conséquence, l'orifice da la tuyère correspondant au flux le plus rapide étant plus étroit que celle de la tuyère correspondant au flux le plus lent.

De toute manière, dans la présente invention on préfère jouer sur le facteur angle, celui-ci étant, de préférence, voisin de 90 à 180°, ce qui veut dire, en d'autres termes, qu'on préfère se faire rencontrer les flux gazeux, soit à angle droit, soit à contre-courant.

On relèvera, en ce qui concerne l'état de la technique, l'existence du document suivant, DD-A-107 723 (PETERMANN), qui décrit un procédé de revêtement par CVD suivant lequel le mélange gazeux est projeté à angle droit sur le substrat. Dans ce procédé, le gaz réactionnel est introduit, avant d'être dirigé sur le substrat, dans une chambre de réaction où il est soumis à un mouvement de turbulence intense et d'où il est conduit sur le substrat sous forme d'un front de turbulence régulier.

Un forme d'exécution du dispositif mettant en œuvre le procédé ci-dessus (voir fig. 4 et page 12 de DD-A-107 723) comporte deux chambres de turbulence placées côte à côte dont les orifices de sortie dirigent les gaz réactifs sur le substrat à revêtir selon deux courants tourbillonnaires orientés parallèlement l'un à l'autre, ces courants se mélangeant de façon intense au cours de leur trajet entre ces orifices et ledit substrat. Ce document ne divulgue cependant pas de moyens permettant de diriger ces courants gazeux, l'un contre l'autre sous un angle supérieur à 35°, ni des moyens pour animer au préalable ces courants de gaz de vitesses différentes de manière à compléter l'effet de mélange dû à la turbulence précédemment acquise. Par ailleurs, on relèvera que, dans cette référence, la turbulence est impartie, soit au courant des gaz déjà mélangés, soit indépendamment à chacun des courants gazeux alors que, dans l'invention, c'est le choc entre ces courants qui engendre essentiellement la turbulence.

L'invention est illustrée par le dessin en annexe qui représente un dispositif permettant de mettre en œuvre le procédé de l'invention. Ce dispositif est destiné à revêtir une plaque de verre «float» d'une couche uniforme de $SnO_2$ transparente et électriquement conductrice à grains très fins, ses éléments constructifs étant particulièrement conçus pour minimiser l'encrassement des organes de projection du $SnO_2$ de revêtement. Il est cependant bien entendu que l'invention peut également convenir pour déposer d'autres revêtements minéraux, par exemple des couches de $TiO_2$, $SiO_2$, Si (par décomposition, par exemple, de $SiH_4$), $In_2O_3$, $ZrO_2$, $Cr_2O_3$, $Fe_2O_3$ et NiO ainsi que leurs mélanges.

La fig. 1 représente, vue de profil, une coupe fragmentaire schématique d'un dispositif à plusieurs buses de projection.

La fig. 2 est une vue schématique en plan des buses suivant la ligne II–II de la fig. 1.

La fig. 3 est une coupe schématique, agrandie, d'une des buses du dispositif de la fig. 1.

La fig. 4 est une représentation schématique des traces du dépôt fourni par le dispositif de la fig. 1.

La fig. 5 constitue une coupe schématique, agrandie, d'une variante de buse de projection.

La fig. 6 représente une seconde variante de buse et

La fig. 7 une troisième variante de buse de projection.

Le dispositif donné ici à titre d'exemple et illustré par les fig. 1, 2 et 3 comprend un boîtier 1 renfermant deux chambres d'alimentation en réactif gazeux, 2 et 3, respectivement pour du $SnCl_4$ et pour de l'eau (celle-ci pouvant éventuellement contenir d'autres additifs, par exemple du HF), et une chambre d'évacuation 4 des gaz issus de la réaction. Le boîtier est équipé de deux séries de buses identiques disposées en quinconce (voir fig. 2), ces buses comportant chacune les éléments suivants: un conduit central 5 relié à la chambre 2, une tuyère coaxiale 6 reliée à la chambre 3 et une tubulure ou enceinte enveloppante 7 d'aspiration communiquant avec la chambre d'évacuation 4. Pour permettre aux réacrifs de se mélanger dans l'embouchure 6a même de la buse, le conduit 5 se termine quelque peu en retrait de l'orifice de la tuyère 6 laquelle comporte un déflecteur 8 destiné à provoquer l'étalement, entre celui-ci et la plaque de verre 9 à revêtir, des gaz de réaction débouchant de l'orifice de la buse, de manière que la zone de ladite plaque située directement en face dudit déflecteur 8 soit revêtue de manière uniforme par le produit réactionnel solide, en l'occurence le $SnO_2$. La plaque de verre «float» 9 repose elle même sur des rouleaux 10 qui l'entraînent en translation horizontale par rapport aux buses et perpendiculairement au dessin de la fig. 1, ceci de manière que le revêtement se dépose progressivement et régulièrement sur celle-ci. Le conduit 5 contient une chicane de forme hélicoïdale, en l'occurence un ressort à boudin 11, dont la présence contraint le courant de gaz descendant dans le conduit 5 à prendre un mouvement de rotation à droite. De même, la tuyère coaxiale 6 comprend un ressort 12 donnant aux gaz qui la parcourent un mouvement levorotatoire. Les gaz issus des orifices des tuyères 5 et 6 se rejoignant dans l'embouchure 6a de la buse se rencontrent donc approximativement à contre-courant (l'angle de rencontre se rapproche de 180°) ce qui assure un mélange quasi-instantané des réactifs. Il est bien entendu que les ressorts 11 et 12 pourraient être remplacés par tous autre moyen de déflexion rotatoire des gaz, des aillettes par exemple.

De plus, en ce qui concerne les ressorts 11 et 12, on notera qu'ils peuvent être de chiralité identique mais de pas différent, ceci de façon que les gaz issus des tuyères se rencontrent sous un angle inférieur à 90°.

Par ailleurs, le dispositif illustré au dessin comporte encore un système d'alimentation contrôlée des réactifs constitué par les organes suivants: une conduite 22 d'entrée dans la chambre 2 reliée, comme représenté schématiquement par la ligne fléchée 23 à un évaporateur 24 sous forme d'un serpentin plongé dans un liquide 25 chauffé à une température convenable pour assurer l'évaporation du $SnCl_4$. Ce réactif, contenu dans un réservoir 26 est injecté en quantité mesurée par une pompe doseuse 27 en amont de l'évaporateur 24 dans la conduite d'alimentation 23. Il est à noter qu'on peut également introduire (mais ceci facultativement) un gaz porteur dans la ligne 23 tel que représenté au dessin. Ce gaz porteur, par exemple un mélange $N_2$ et $H_2$ permet de plus ou moins diluer la vapeur de $SnCl_4$ et permet un contrôle efficace de son débit dans les buses du présent dispositif. Ce dernier comporte encore, comme représenté au dessin, une alimentation en eau tout à fait similaire à celle du $SnCl_4$, cette alimentation en eau comprenant la conduite d'entrée 32, la ligne d'alimentation 33, l'évaporateur 34 chauffé par le liquide 35 et la pompe doseuse 36 permettant de mesurer exactement le débit de l'eau du réservoir 37. Par ailleurs, la chambre d'évacuation 4 est reliée, par une conduite d'aspiration représentée par la fléche 38, à un système classique d'aspiration et de dépollution des gaz non représenté ici. Il est encore à noter que les chambres 2 et 3 contiennent un système de chicanes (connues en soi et non représentées au dessin) destinées à répartir la pression et le débit des gaz uniformément dans chaque buse du présent dispositif. A ce propos on voit, d'après le dessin, que les deux rangs de cinq buses du dispositif sont décalés en quinconce, cette disposition ayant pour but de faire en sorte que les dépôts provenant des buses du second rang viennent s'intercaler, sur le verre, entre les dépôts formés par les buses du premier rang. Le résultat de cet arrangement est illustré schématiquement à la fig.

4 où on a représenté par une première sinusoïde 41 le profil de la trace (théorique d'ailleurs car, en fait, ce profil affecte plutôt la forme d'une suite de créneaux) constitué par le dépôt issu du premier rang de buses et par une deuxième sinusoïde 42, le profil de la trace du dépôt du second rang de buses. Les aires ombrées 43 représentent la somme (par intégration) des dépôts sur les zones communes aux deux séries sinusoïdales de dépôts et, de toute évidence, cette somme correspond, en tant qu'entité physique, à l'aire ponctuée 44 qui, en quelque sorte, remplit les «vides» existant entre les crêtes des sinusoïdes 41 et 42. Ainsi, la forme du dépôt final correspond à la courbe enveloppe 45 ce qui démontre que le dépôt global obtenu par le présent dispositif est régulier et d'épaisseur pratiquement constantel. Il est d'ailleurs possible, si on désire faire varier le degré d'empiètement d'un des jeux de traces sur l'autre et si l'envergure opérationnelle du jeu de buses est suffisante par rapport à la largeur de la plaque de verre, de faire pivoter légèrement le dispositif de revêtement autour d'un axe vertical fictif 50, le tout de manière à décaler latéralement les traces de l'un des rangs de buses par rapport à l'autre.

On remarquera encore que bien que le présent dispositif ait été limité à deux rangs de cinq buses, on peut aisément prévoir un nombre supérieur de ces rangs, par exemple 3, 4, 5 ou plus, ceci afin de renforcer l'épaisseur du dépôt global et un nombre quelconque de buses dans chaque rang.

La fig. 5 représente une première variante de la buse de l'invention. Comme dans la buse de la fig. 3, cette variante comporte une tuyère centrale 55, une tuyère coaxiale 56, une enceinte d'aspiration 57 et des ressorts déflecteurs 61 et 62. Les déflecteurs 8 de la buse de la fig. 3 sont par contre remplacés dans la présente variante par un tampon annulaire 63 en matière poreuse, par exemple une céramique ou un métal fritté (Cu, Ni, Fe, etc . . .), logé à l'extrémité d'une tubulure coaxiale intermédiaire 64 reliée à une chambre additionnelle d'alimentation en gaz non représentée au dessin. La forme tronconique du tampon permet de faire en sorte que le débit d'un gaz (un gaz porteur) admis par la tubulure 64 et traversant ce tampon se répartisse en fonction de la charge constituée par le matière poreuse de ce tampon: plus faible à l'extérieur que vers le centre. On pourra donc par ce biais régler de façon très efficace les conditions de dispersion des gaz de réaction à la sortie de la buse, le gaz porteur issu de la tuyère 64 jouant le rôle de coussin d'air dont la répartition (voir les flèches 65 du dessin) agit sur la distribution du milieu réactionnel gazeux entre la sortie de la buse, la plaque de verre et l'enceinte d'aspiration 57. Cette variante permet d'encore améliorer la régularité et l'homogénéité de la couche de revêtement.

La fig. 6 représente schématiquement l'extrémité d'une 2ème variante de buse. Elle comprend, comme dans les cas déjà décrits, une tuyère centrale 71, une tuyère coaxiale 72, une enceinte d'aspiration 74 et des ressorts 75 et 76 faisant tourner les flux descendant les tuyères 71 et 72 en sens contraire. Cependant, contrairement à la buse de la fig. 3, les orifices des deux tuyères sont au même niveau et débouchent dans un zone tronconique 77 de réaction dont les parois obliques sont constituées d'un déflecteur annulaire 78 dont la face inférieure est biseautée comme indiqué au dessin. Il résulte de la forme spéciale de la zone 77 une régularisation du mouvement radial des gaz issus de la buse en direction de l'enceinte d'aspiration 74, phénomène qui contribue à assurer un dépôt régulier sur la plaque 9.

La fig. 7 représente l'extrémité inférieure d'une troisième variante de buse. Celle-ci comprend une tuyère centrale 81 munie d'une chicane hélicoïdale 82 donnant aux gaz descendant dans cette tuyère un mouvement de rotation à droite comme indiqué par la flèche 83. La buse comprend encore une tuyère coaxiale 84 pourvue, à son extrémité, d'un tampon tronconique 85 de matière perméable aux gaz. Cette matière peut être une céramique ou un métal fritté ou une feuille de tôle ondulée, de cuivre par exemple, enroulée sur elle-même de manière à constituer une charge au passage du gaz parcourant la tuyère 84, cette charge servant à régulariser et à répartir, suivant un plan radial, les gaz issus de ladite tuyère. Le tampon 85 peut également être constitué de poils métalliques (brosse perméable au gaz) sertis entre les parois des tuyères d'une manière connue en soi, par exemple par un bossage annulaire non représenté au dessin des parois de la tuyère 84. La matière du tampon (céramique, feuille enroulée, poils métalliques ou fibres de verre, etc . . .) doivent, bien entendu ne pas être susceptible d'attaque par la vapeur d'eau surchauffée; la fibre de verre, le cuivre, le nickel, le bronze et l'acier inoxydable conviennent à cet usage.

La vapeur d'eau pure ou mélangée au gaz porteur inerte débouche verticalement de la tuyère 84 (voir flèches 86) et est heurtée approximativement perpendiculairement par le gaz en rotation issu de la tuyère 81. Il s'agit donc là d'un cas de rencontre des flux réactifs sous un angle voisin de 90°. On notera aussi que, avec le tampon 85 décrit ici, le débit global de gaz est approximativement 3 à 4 fois plus lent dans la tuyère extérieure 84 que dans la tuyère centrale 81. En conséquence, lorsqu'on utilise avec une telle buse des courants de gaz (par exemple $SnCl_4$ et $H_2O$) en volumes sensiblement égaux, c'est-à-dire 1 mole de $SnCl_4$ diluée dans 1 volume de gaz porteur pour deux volumes de vapeur d'eau, on prévoit une ouverture de tuyère 84 dont la section utile est environ 3 à 4 fois celle de la tuyère centrale. En d'autres termes, si la tuyère centrale a 4 mm de diamètre intérieur, c'est-à-dire une section droite de 12 $mm^2$ environ, la tuyère coaxiale extérieure aura un diamètre d'environ 8 mm, c'est-à-dire une section utile de $48-12=36$ $mm^2$, l'épaisseur des parois étant négligée.

Bien entendu, alternativement, on peut modifier la porosité du tampon 85 de manière que le débit global de la tuyère 84 soit le double, par exemple, de celui de la tuyère 81, ce qui permet alors de faire parvenir simultanément dans la buse

1 volume de vapeur de $SnCl_4$ pur (1 mole), par la tuyère centrale, pour 2 volumes de vapeur d'eau non diluée, par la tuyère 84, suivant la réaction générale:

$$SnCl_4 + 2\,H_2O \rightarrow SnO_2 + 4\,HCl$$

Toutes modifications de ce genre accessibles à l'homme de métier par simples variations des cotes des buses et des paramètres opérationnels font, bien entendu, partie de l'invention.

Le fonctionnement du présent dispositif se déduit tout naturellement de la description qui précède. La plaque de verre, constituée en fait par un ruban continu de verre «float», circule à une vitesse convenable, par exemple, de l'ordre de 5 à 25 m/min, entraînée par les rouleaux 10 et sa température à la sortie du four de «Float» est de l'ordre de 450–600 °C. Ce ruban de verre circule à une distance de l'ordre de 1 à 5 mm de la sortie des buses du présent dispositif. Simultanément, par le jeu des pompes doseuses 27 et 36 et des évaporateurs 24 et 34, on envoi des quantités de $SnCl_4$ et de vapeur d'eau à travers les tuyères 5 et 6, respectivement, de manière que les réactifs se mélangent à contre-courant à l'embouchure des buses et que le produit de réaction se dépose sur la plaque en mouvement. Pour réaliser une évaporation suffisante du $SnCl_4$ et de l'eau dans les évaporateurs, en l'absence ou en présence d'un gaz porteur, ceux-ci sont chauffés par exemple par bain d'huile ou de polyalcoylène glycol entre environ 120 et 200 °C, 150° étant une moyenne avantageuse. De plus, pour éviter une condensation des réactifs dans les chambres d'alimentation ou dans les buses, tous ces organes sont également maintenus à une température suffisante (120–200°), le chauffage étant assuré, soit par des moyens non représentés mais classiques (corps de chauffe électrique, par exemple), soit par le rayonnement direct du ruban de verre float.

Au point de vue débit, à une vitesse de défilement de 5 m/min, en utilisant des buses de largeur hors-tout de 15 mm avec un tube 5 de 1,8–2 mm, un tube 6 de 2,8 à 3 mm et un déflecteur 8 de 10 mm et en comptant 2000 buses par rangées pour un ruban de verre de 300 cm de large avec dix rangs de buses chacun en quinconce par rapport aux autres, on utilisera de 5 à 100 $Nm^3$ de vapeur de $SnCl_4$ par h et de 10 à 200 $Nm^3$ de vapeur d'eau par h (ces volumes désignés $Nm^3$ (normal-mètre-cube) sont comptés à température et pression ordinaires) sans gaz porteur. Dans de telles conditions, on peut obtenir des dépôts parfaitement transparents et homogènes de $SnO_2$ de 0,5 à 1,5 µ d'épaisseur et de résistance $R_\square$=10 à 1,5 Ω.

En ajoutant aux réactifs un gaz porteur, par exemple un mélange $N_2/H_2$ en proportions 20/80 à 0/100 au taux par exemple de 1 litre de gaz porteur par litre de réactif, on pourra admettre des débits globaux de l'ordre de 20 $Nm^3$ à 400 $Nm^3/h$ au maximum.

On notera que les pressions (et bien entendu les débits) d'aspiration seront supérieures aux pressions d'alimentation, de manière à toujours assurer une évacuation parfaite des gaz réactionnels et éviter l'encrassement des organes de dépôt.

L'exemple qui suit illustre l'invention.

On a utilisé un appareil conforme à la présente description et on l'a utilisé pour revêtir d'une couche de $SnO_2$ transparente et électriquement conductrice un ruban de verre float d'une largeur de 30 cm se déplaçant à la vitesse de 5 m/min, et porté à la température de 600 °C.

Le dispositif utilisé avait les caractéristiques suivantes:

Nombre de rangées de buses: 10 (cinq doubles rangées en quinconce).

Nombre de buses par rangées: 20.

Paramètres constructifs des buses: parois des tuyères, épaisseur: 0,1 mm; ∅ du tube intérieur 5: 1,8 mm; ∅ de la tuyère coaxiale 6: 2,8 mm; surface utile des orifices de sortie des tubes 5 et 6: 3,1 $mm^2$; distance entre les embouchures des tubes 5 et 6: 1 mm; distance entre verre et buses: 2 mm; ∅ du déflecteur 8: 10 mm; diamètre de l'enceinte d'aspiration: 14 mm; distance entre les buses (d'axe à axe): 15 mm; température du boîtier et des buses: 150 °C.

Dans le réservoir 26 on a placé du $SnCl_4$ distillé de pureté 99,9% et dans le réservoir 37 de l'eau bidistillée additionnée de 5% de HF. On a chauffé les évaporateurs 24 et 34 à 150° au moyen d'un bain d'huile chauffé élctriquement et on a fait débiter le $SnCl_4$ par la pompe 27 à la cadence de 10,6 l/h et l'eau par la pompe 36 à la cadence de 32 l/h. On a introduit par la ligne 23 2 $Nm^3/h$ d'un mélange $N_2/H_2$ 60/40; on n'a pas introduit de gaz porteur par la ligne 33.

On a ainsi déposé sur le ruban de verre une couche de $SnO_2$ de 1 u dont la transparence était de 80% et la résistance $R_\square$ de 3 Ω.

On a pu faire fonctionner le présent appareil pendant 30 minutes sans observer d'encrassement notable des buses et sans que les paramètres de revêtement changent de façon significative. Après cette période, on a arrêté l'appareil, on l'a laissé refroidir et on a fait circuler de l'eau à température ambiante dans les chambres d'alimentation et les buses afin de le nettoyer par rinçage.

**Revendications**

1. Procédé pour revêtir un substrat d'une couche de matière minérale consistant à diriger sur ledit substrat chauffé à température élevée des courants ou flux gazeux d'un ou plusieurs réactifs, ceux-ci s'unissant à proximité immédiate du substrat en y déposant, sous forme d'un revêtement, un produit résultant de la décomposition ou de la réaction du ou desdits réactifs, caractérisé par le fait qu'on fait se heurter les courants gazeux avant leur contact avec le substrat en les dirigeant l'un vers l'autre soit sous un angle supérieur à 35 degrés, soit en les animant, au préalable, de vitesses différentes avec un rapport de vitesses affectant deux d'entre eux d'au moins 1,5, soit en combinant les deux effets précités, le tout de manière à provoquer, en raison de l'agitation produite par la

collision, un mélange quasi-instantané desdits flux gazeux.

2. Procédé suivant la revendication 1, caractérisé par le fait que l'angle de rencontre varie de 60 à 180 degrés.

3. Procédé suivant la revendication 1, caractérisé par le fait que le rapport entre la vitesse de l'un des courants et celle d'au moins l'un des autres varie de 1,5: 1 à 20:1.

4. Procédé suivant la revendication 1, caractérisé par le fait qu'il fait intervenir deux courants gazeux de vitesses et de débits sensiblement égaux qui se heurtent à contre-courant au point d'impact.

5. Procédé suivant la revendication 4, caractérisé par le fait qu'avant leur rencontre, les courants sont animés de mouvements hélicoïdaux de sens contraires.

6. Procédé suivant la revendication 4, caractérisé par le fait qu'un des courants comprend du $SnCl_4$ et l'autre de la vapeur d'eau, le produit de réaction étant un dépôt de $SnO_2$ transparent et conducteur de l'électricité.

7. Dispositif pour mettre en œuvre le procédé suivant la revendication 1, comportant un jeu de buses parallèles de projection du ou des réactifs sur le substrat (9), chaque buse comprenant au moins deux tuyères (5, 6) transportant, respectivement, un premier et un second flux gazeux porteurs de réactifs, ces tuyères imprimant à ces flux des trajectoires respectives qui convergent à l'embouchure de la buse, la collision de ces flux provoquant leur mélange quasi instantané, caractérisé par le fait que chaque buse comprend une première tuyère centrale (5) transportant un premier flux gazeux et, coaxialement avec celle-ci, une seconde tuyère (6) transportant un second flux gazeux, l'une ou les deux tuyères contenant, au moins sur une partie de leur longeur, des chicanes (11, 12) impartissant au flux qui la parcourt un mouvement tel que la rencontre des flux à l'embouchure de la buse se fait sous un angle d'au moins 60°.

8. Dispositif suivant la revendication 7, caractérisé par le fait que les tuyères contiennent des systèmes de chicanes agissant en sens contraire l'un de l'autre et imprimant aux flux parcourant les tuyères un mouvement de contre-rotation l'un par rapport à l'autre.

9. Dispositif suivant la revendication 8, caractérisé par le fait que les chicanes sont des ailettes ou des ressorts à boudin.

10. Dispositif suivant la revendication 8, caractérisé par le fait que les tuyères centrales (5) des buses communiquent toutes avec une première chambre d'alimentation (2) du premier flux gazeux, et que, de même, les secondes tuyères (6) communiquent toutes avec une unique seconde chambre d'alimentation (3) du second flux gazeux, chaque chambre contenent des chicanes pour répartir uniformément la pression desdits flux entre les tuyères qui y sont reliées.

11. Dispositif suivant la revendication 8, caractérisé par le fait que l'orifice de la tuyère centrale des buses se situe en retrait de l'orifice de la seconde tuyère qui lui est coaxiale, lequel constitue l'embouchure (6a) proprement dite de la buse, l'espace compris entre les deux orifices constituant la zone d'impact et de mélange des flux gazeux mis en jeu, et que le produit de réaction formé est alors projeté hors de ladite embouchure sur le substrat (9).

12. Dispositif suivant la revendication 8, caractérisé par le fait que chaque buse comporte un déflecteur annulaire (8) fixé à la seconde tuyère (6) concentriquement à celle-ci, ce déflecteur étant prévu pour forcer les gaz de réaction à s'étaler entre la buse et le substrat.

13. Dispositif suivant la revendication 12, caractérisé par le fait que les buses comportent, en outre, une enceinte tubulaire concentrique (7) de diamètre supérieur à celui dudit déflecteur, chaque enceinte communicant avec une chambre d'aspiration (4) des produits gazeux de réaction.

14. Dispositif suivant la revendication 8, caractérisé par le fait que les flux gazeux comprennent les réactifs en phase vapeur, soit à l'état pur, soit en mélange avec un gaz porteur.

15. Dispositif suivant la revendication 14, caractérisé par le fait qu'il comprend des évaporateurs (24, 34) chauffés pour évaporer les réactifs à l'état liquide, des pompes doseuses (27, 36) pour injecter des quantités contrôlées de réactif dans lesdits évaporateurs et des conduits (22, 32) pour acheminer les flux gazeux contenant les réactifs dans les chambres respectives d'alimentation (2, 3).

16. Dispositif suivant la revendication 8, caractérisé par le fait que chaque buse comprend, en plus, une troisième tuyère (64) coaxiale avec les deux autres (55, 56) dont l'orifice est à niveau avec la seconde tuyère (56) et dont l'embouchure est garnie d'un tampon de matière poreuse (63), cette tuyère étant parcourue par un gaz inerte dont la pression, à la sortie de la buse, est répartie radialement en fonction de l'effet de charge due audit tampon et qui joue le rôle de déflecteur, entre la buse et le substrat (9), des gaz de réaction, le tout étant adapté pour que le produit solide se dépose sur ledit substrat de manière régulière et contrôlée.

17. Dispositif suivant la revendication 12, caractérisé par le fait que la face inférieure du déflecteur (8) est plane et parallèle à la feuille de verre à revêtir.

18. Dispositif suivant la revendication 12, caractérisé par le fait que le déflecteur (78) présente sur sa face inférieure une cavité tronconique (77) au sommet de laquelle débouchent les orifices des tuyères, cette cavité (77) constituant la zone de mélange et de réaction des gaz issus desdites tuyères.

19. Dispositif suivant la revendication 7, caractérisé par le fait que la tuyère centrale (81) est munie de chicanes hélicoïdales (82) imprimant au premier flux gazeux un mouvement tournant et que la tuyère coaxiale (84) est pourvue, à son extrémité, d'un tampon (85) de matière perméable au gaz régularisant le débit du second flux gazeux émergeant verticalement de l'orifice de ladite tuyère coaxiale (84) et venant heurter sous un angle voisin de 90° le premier flux tournant issu de la tuyère (81).

**Patentansprüche**

1. Verfahren zum Überziehen eines Substrats mit einer Schicht von mineralischem Stoff, das darin besteht, auf das auf erhöhte Temperatur erhitzte Substrat gasförmige Ströme oder Flüsse eines oder mehrerer Reaktionsmittel zu richten, die sich ganz dicht am Substrat vereinigen, indem sie dort ein sich aus dem Zerfall oder der Reaktion des oder der Reaktionsmittel ergebendes Produkt in Form eines Überzuges ablagern, dadurch gekennzeichnet, dass man die gasförmigen Ströme vor ihrer Berührung mit dem Substrat aufeinanderprallen lässt, indem man sie gegeneinander richtet, sei es unter einem Winkel grösser als 35°, sei es, indem man sie vorher mit verschiedenen Geschwindigkeiten mit einem Geschwindigkeitsverhältnis zweier unter ihnen zueinander von mindestens 1,5 anregt, sei es, indem man die beiden vorerwähnten Wirkungen kombiniert, derart, dass aufgrund der durch das Aufeinanderprallen erzeugten Bewegung eine quasi-augenblickliche Mischung der gasförmigen Flüsse entsteht.

2. Verfahren nach Anspruch 1, dadurch gekennzeichnet, dass der Winkel des Auftreffens zwischen 60 und 180 Grad liegt.

3. Verfahren nach Anspruch 1, dadurch gekennzeichnet, dass das Verhältnis zwischen der Geschwindigkeit des einen der Ströme und derjenigen mindestens eines der anderen zwischen 1,5:1 bis 20:1 variiert.

4. Verfahren nach Anspruch 1, dadurch gekennzeichnet, dass zwei gasförmige Ströme mit im wesentlichen gleichen Geschwindigkeiten und Durchflussmengen sich beeinflussen lassen, die im Gegenstrom am Aufschlagpunkt aufeinanderprallen.

5. Verfahren nach Anspruch 4, dadurch gekennzeichnet, dass die Ströme vor ihrem Auftreffen zu schraubenförmigen Bewegungen in gegensätzlichen Richtungen angeregt werden.

6. Verfahren nach Anspruch 4, dadurch gekennzeichnet, dass einer der Ströme $SnCl_4$ enthält und der andere Wasserdampf, wobei das Reaktionsprodukt eine Ablagerung von durchsichtigem und elektrisch leitendem $SnO_2$ ist.

7. Vorrichtung zur Durchführung des Verfahrens nach Anspruch 1 mit einem Satz paralleler Gebläse für das Auswerfen des oder der Reaktionsmittel auf das Substrat (9), wobei jedes Gebläse mindestens zwei Düsen (5, 6) aufweist, die einen ersten bzw. einen zweiten gasförmigen Fluss von Reaktionsmittelträgern fördern, wobei diese Düsen diesen Flüssen entsprechende Bahnen auferlegen, die an der Mündung des Gebläses zusammenlaufen, und das Zusammentreffen dieser Flüsse ihre quasi-augenblickliche Mischung hervorruft, dadurch gekennzeichnet, dass jedes Gebläse eine erste Zentraldüse (5), die einen ersten gasförmigen Fluss fördert, und koaxial zu dieser eine zweite Düse (6) aufweist, die einen zweiten gasförmigen Fluss fördert, wobei die eine oder beide Düsen mindestens auf einen Teil ihrer Länge Einbauten (11, 12) enthalten, die dem sie durchlaufenden Fluss eine solche Bewegung aufzwingen, dass das Auftreffen der Flüsse an der Mündung des Gebläses unter einem Winkel von mindestens 60° erfolgt.

8. Vorrichtung nach Anspruch 7, dadurch gekennzeichnet, dass die Düsen Einbautensysteme aufweisen, die in entgegengesetzter Richtung zueinander wirken und den durch die Düsen fliessenden Flüssen eine Gegendrehungsbewegung der einen in bezug auf die andere auferlegen.

9. Vorrichtung nach Anspruch 8, dadurch gekennzeichnet, dass die Einbauten Flügel oder Schraubenfedern sind.

10. Vorrichtung nach Anspruch 8, dadurch gekennzeichnet, dass die Zentraldüsen (5) der Gebläse sämtlich mit einer ersten Speisekammer (3) des ersten Gasflusses in Verbindung stehen, und dass in gleicher Weise die zweiten Düsen (6) sämtlich mit einer einzigen zweiten Speisekammer (3) des zweiten Gasflusses in Verbindung stehen, wobei jede Kammer Einbauten enthält, um den Druck dieser Flüsse zwischen den mit ihnen verbundenen Düsen gleichmässig zu verteilen.

11. Vorrichtung nach Anspruch 8, dadurch gekennzeichnet, dass die Öffnung der Zentraldüse der Gebläse in bezug auf die Öffnung der mit ihr koaxial verlaufenden zweiten Düse zurückgesetzt angeordnet ist, die die eigentliche Mündung (6a) des Gebläses bildet, wobei der Raum zwischen den beiden Öffnungen die Aufschlag- und Mischzone für die im Spiel befindlichen Gasflüsse bildet, und dass das gebildete Reaktionsprodukt dann aus der Mündung hinaus auf das Substrat (9) ausgeworfen wird.

12. Vorrichtung nach Anspruch 8, dadurch gekennzeichnet, dass jedes Gebläse eine ringförmige Ablenkplatte (8) aufweist, die an der zweiten Düse (6) befestigt ist und konzentrisch zu dieser verläuft, wobei diese Ablenkplatte vorgesehen ist, um das Reaktionsgas zu zwingen, sich zwischen dem Gebläse und dem Substrat zu verteilen.

13. Vorrichtung nach Anspruch 12, dadurch gekennzeichnet, dass die Gebläse ausserdem einen röhrenförmigen konzentrischen Behälter (7) aufweisen, dessen Durchmesser grösser ist als der der Ablenkplatte, wobei jeder Behälter an eine Ansaugkammer (4) für gasförmige Reaktionsprodukte angeschlossen ist.

14. Vorrichtung nach Anspruch 8, dadurch gekennzeichnet, dass die gasförmigen Flüsse die Reaktionsmittel in Dampfphase entweder in reinem Zustand oder in Mischung mit einem Trägergas enthalten.

15. Vorrichtung nach Anspruch 14, dadurch gekennzeichnet, dass sie Verdampfer (24, 34) aufweist, die zum Verdampfen der Reaktionsmittel in Flüssigzustand erhitzt werden, Dosierpumpen (27, 36) zum Injizieren der gesteuerten Mengen Reaktionsmittel in die Verdampfer und Leitungen (22, 32) zum Befördern der gasförmigen,

die Reaktionsmittel enthaltenden Flüsse in die entsprechenden Speisekammern (2, 3).

16. Vorrichtung nach Anspruch 8, dadurch gekennzeichnet, dass jedes Gebläse ausserdem eine dritte Düse (64) aufweist, die koaxial zu den beiden anderen (55, 56) verläuft, deren Öffnung mit der zweiten Düse (56) auf gleicher Ebene liegt und deren Mündung mit einem Puffer aus porösem Material (63) versehen ist, wobei diese Düse von einem Inertgas durchflossen wird, dessen Druck am Ausgang des Gebläses aufgrund des Puffers radial als Funktion der Ladungswirkung verteilt wird, und der zwischen dem Gebläse und dem Substrat (9) die Rolle der Ablenkplatte für die Reaktionsgase spielt, wobei das Ganze so angepasst ist, dass das Festprodukt sich auf dem Substrat in regelmässiger und gesteuerter Weise ablagert.

17. Vorrichtung nach Anspruch 12, dadurch gekennzeichnet, dass die Unterseite der Ablenkplatte (8) eben ist und parallel zu der zu überziehenden Glasplatte verläuft.

18. Vorrichtung nach Anspruch 12, dadurch gekennzeichnet, dass die Ablenkplatte (78) auf ihrer Unterseite eine kegelstumpfförmige Ausnehmung (77) bildet, an deren höchster Stelle die Öffnungen der Düsen einmünden, wobei diese Ausnehmung (77) den Mischungs- und Reaktionsbereich der aus den Düsen ausgestossenen Gase bildet.

19. Vorrichtung nach Anspruch 17, dadurch gekennzeichnet, dass die Zentraldüse (81) mit schraubenförmigen Einbauten (82) versehen ist, die dem ersten Gasstrom eine Drehbewegung auferlegen, und dass die koaxiale Düse (84) an ihrem Ende mit einem Puffer (85) aus für das Gas durchdringbarem Stoff versehen ist, der die Durchflussmenge des zweiten, vertikal aus der Mündung der koaxialen Düse ausströmenden Gasflusses reguliert und in einem Winkel nahe 90° auf den ersten Drehfluss aufprallt, der aus der Düse (81) ausgestossen wird.

## Claims

1. Method for coating a substrate with a layer of mineral material consisting of directing onto the said substrate heated to a high temperature gaseous streams or flows of one or more reagents, the latter joining in the immediate vicinity of the substrate and depositing thereon a product, in the form of a coating, resulting from the decomposition or reaction of the said reagent(s), characterized in that gaseous streams are caused to run into each other before contacting the substrate either by moving them beforehand at different speeds, the speed ratio of at least two of them being at least 1,5, or by directing them towards each other at an angle greater than 35 degress or by combining the above two effects, so as to cause an almost instantaneous mixture of the said gaseous flows by virtue of the stirring effect resulting from the shock.

2. Method according to claim 1, characterized in that the meeting angle varies between 60 and 180 degrees.

3. Method according to claim 1, characterized in that the ratio of the speed of one of the streams to that of at least one of the others varies between 1,5:1 to 20:1.

4. Method according to claim 1, characterized in that two gaseous streams with substantially equal speeds and rates of flow are used to meet in counter-flow at the point of impact.

5. Method according to claim 4, characterized in that before the streams meet, they are caused to move in a helical manner in opposite directions.

6. Method according to claim 4, characterized in that one of the streams contains $SnCl_4$ and the other contains water vapour, the reaction product being a transparent and electrically conductive deposit of $SnO_2$.

7. Device for performing the method according to claim 1, comporting a set of parallel nozzles for spraying the reagent(s) onto the substrate (9), each nozzle comprising at least two pipes (5, 6) conveying respectively a first and second gaseous flow bearing the reagents, these pipes being directed to cause these flows to converge at the mouth of the nozzle, the meeting of these flows causing them to mix almost instantaneously, characterized in that each nozzle comprises a first central pipe (5) conveying a first gaseous flow and, coaxially with this pipe, a second pipe (6) conveying a second gaseous flow, one or both of the pipes containing at least over part of their length, baffles (11, 12) providing the flows which travel therethrough with a movement such that the flows meet at the mouth of the nozzle at an angle of at least 60°.

8. Device according to claim 7, characterized in that the pipes contain baffle systems acting in opposite directions from one another and imparting to the flows passing through the pipes a counter-rotational movement with respect to one another.

9. Device according to claim 8, characterized in that the baffles are ribs or coil springs.

10. Device according to claim 8, characterized in that the central pipes (5) of the nozzles all communicate with a first chamber (2) for the supply of the first gaseous flow, and in that similarly the second pipes (6) all communicate with a single second chamber (3) for the supply of the second gaseous flow, each chamber containing baffles for uniformly distributing the pressure of the said flows between the pipes connected thereto.

11. Device according to claim 8, characterized in that the aperture of the central pipe of the nozzles is located behind the aperture of the second pipe which is coaxial thereto and forms the actual mouth (6a) of the nozzle, the space between the two apertures forming the impact and mixing zone of the two gaseous flows used, and in that the reaction product formed is then sprayed out of the said mouth onto the substrate (9).

12. Device according to claim 8, characterized in that each nozzle comprises an annular deflector (8) fixed to the second pipe (6) concentrically thereto, this deflector being provided in order to

force the reaction gases to spread out between the nozzle and the substrate.

13. Device according to claim 12, characterized in that the nozzles also comprise a concentric tubular chamber (7) with a diameter greater than that of the said deflector, each chamber communicating with a suction chamber (4) for the gaseous reaction products.

14. Device according to claim 8, characterized in that the gaseous flows comprise reagents in the vapour stage, either in the pure state or mixed with a carrier gas.

15. Device according to claim 14, characterized in that it comprises evaporators (24, 34) heated so as to evaporate the reagents in the liquid state, metering pumps (27, 30) for injecting controlled quantities of the reagent into the said evaporators and conduits (22, 32) for directing the gaseous flows containing the reagents into the respective supply chambers (2, 3).

16. Device according to claim 8, characterized in that each nozzle also comprises a third pipe (64) coaxial with the two others (55, 56) and the aperture of which is on a level with the second pipe (56) and the mouth of which is equipped with a plug (63) made of a porous material, this pipe being passed through by an inert gas, the pressure of which at the outlet of the nozzle, is distributed radially as a function of the effect of the resistance due to the said plug and which acts as a deflector, between the nozzle and the substrate (9), for the reaction gases, the whole being adapted such that the solid product is deposited on the said substrate in a uniform and controlled manner.

17. Device according to claim 12, characterized in that the lower face of the deflector (8) is flat and parallel to the sheet of glass to be coated.

18. Device according to claim 12, characterized in that the deflector (78) has on its lower face a frustoconical cavity (77) at the top of which the apertures of the pipes open, this cavity (77) forming the mixing and reaction zone of the gases from the said pipes.

19. Device according to claim 7, characterized in that the central pipe (81) is equipped with helical baffles (82) imparting to the first gaseous flow a rotating movement and in that the end of the coaxial pipe (87) is provided with a plug (85) made of a gas-permeable material and regulating the rate of flow of the second gaseous flow emerging vertically from the aperture of the said coaxial pipe (84) and meeting the first rotating flow from the pipe (81) at an angle of approximately 90°.

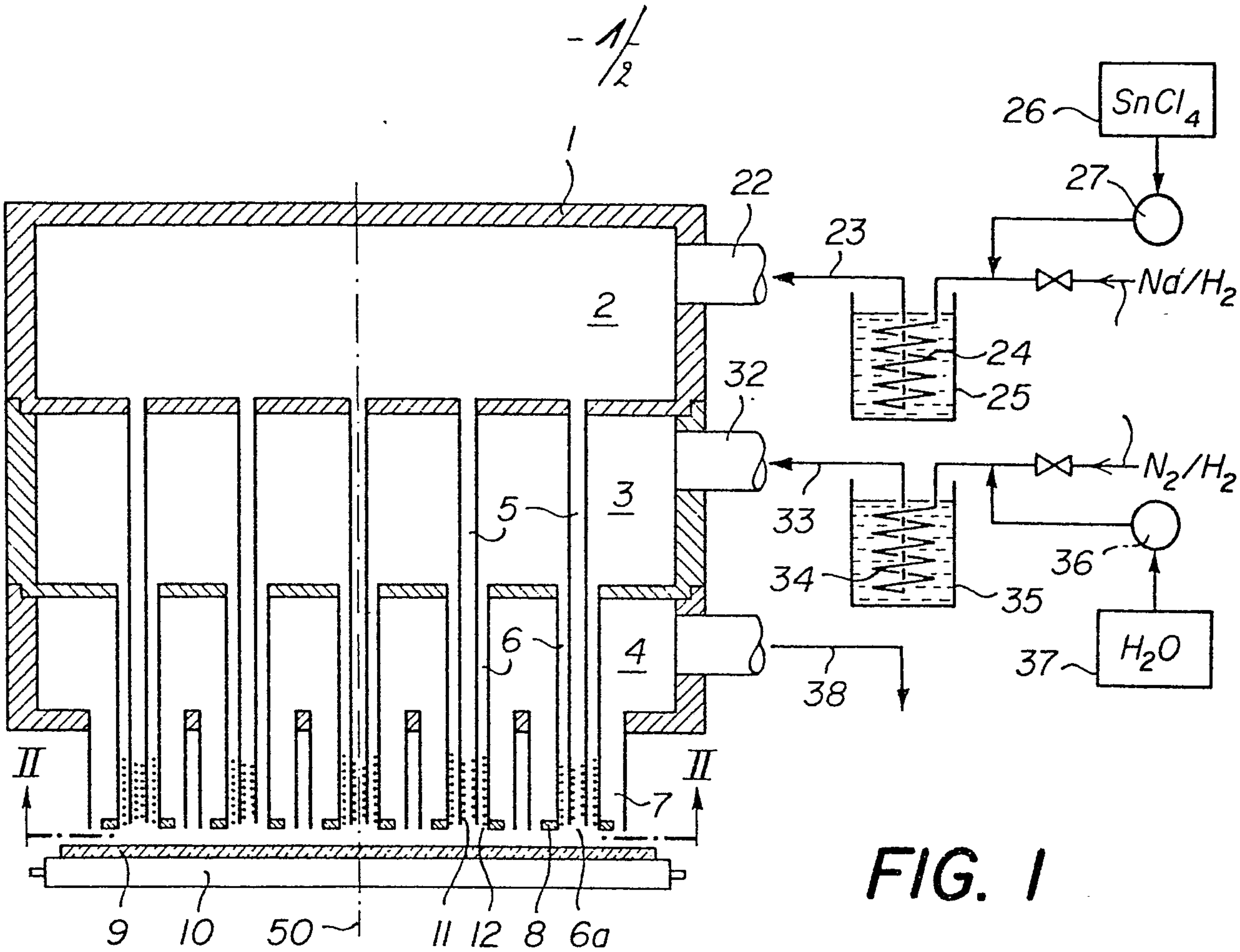


FIG. 1

FIG. 2

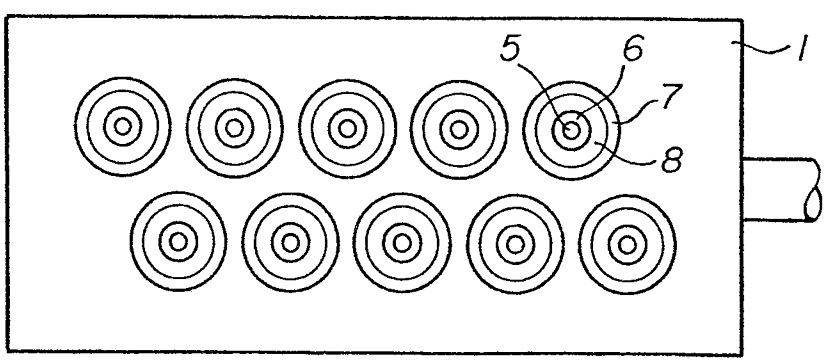


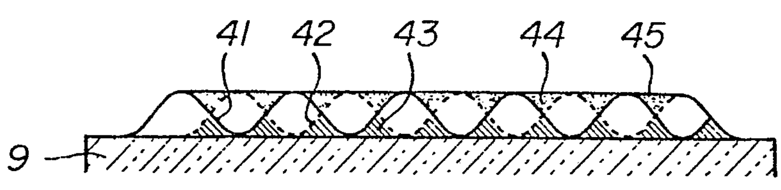


FIG. 4

2/2

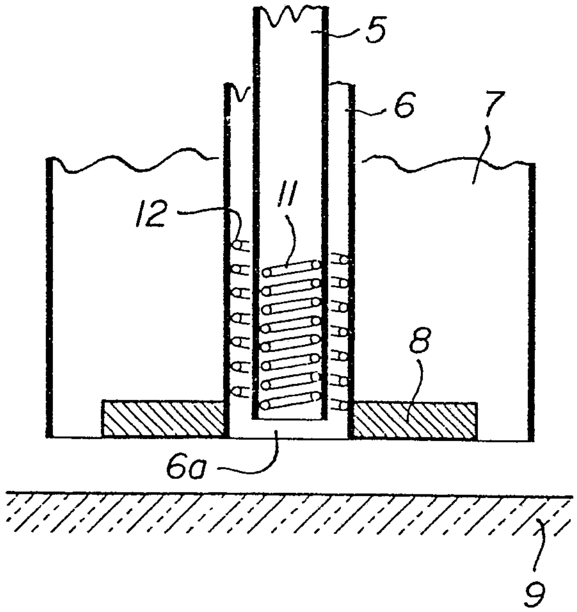


FIG. 3

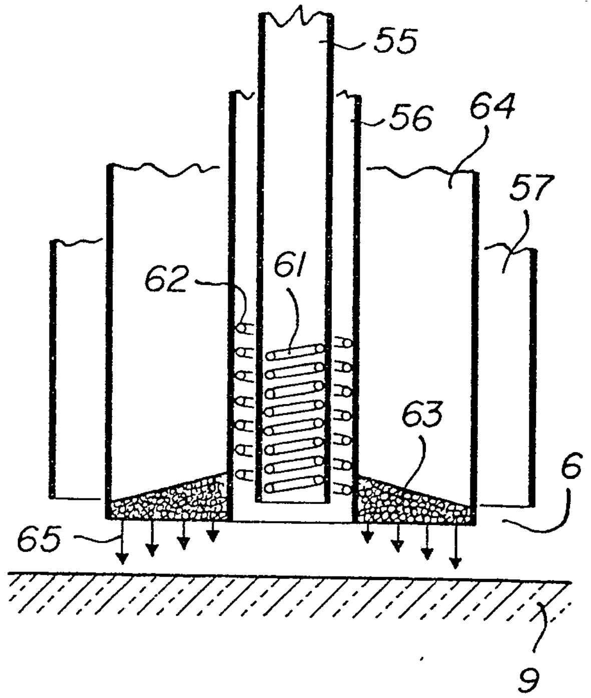


FIG. 5

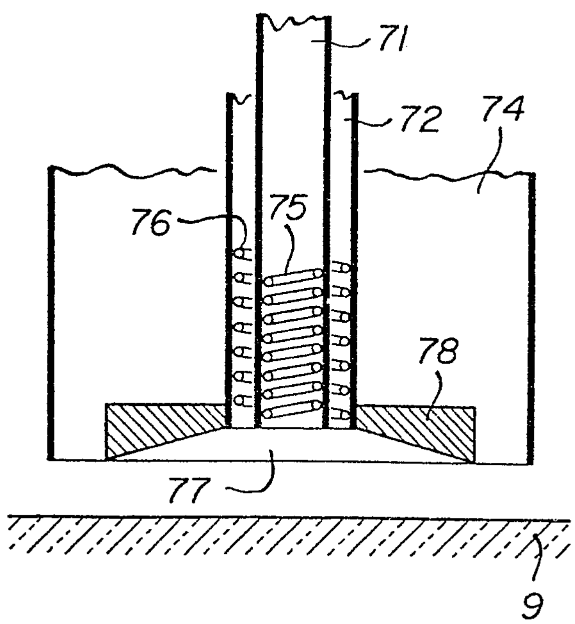


FIG. 6

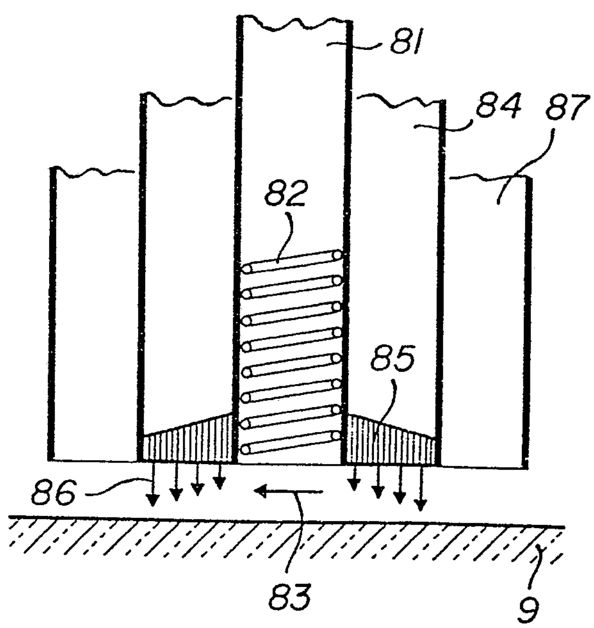


FIG. 7